# EUROPEAN PATENT APPLICATION

(11) **EP 4 665 091 A1**
(43) Date of publication of application: **17.12.2025**
(21) Application number: 25720812.4
(22) Date of filing: 29.04.2025
(51) Int. Cl.: H05K 1/02, H05K 7/20, H05K 9/00, C09K 5/02, H04M 1/02, H01L 23/42, H01L 23/538, H10B 12/00, H01L 25/065

(54) **ELECTRONIC DEVICE INCLUDING HEAT CONDUCTOR**

(30) Priority: 30.04.2024 KR 20240058094; 12.07.2024 KR 20240092440; 26.09.2024 KR 20240130812
(71) Applicant: Samsung Electronics Co., Ltd, Suwon-si, Gyeonggi-do 16677 (KR)
(72) Inventor: KIM, Chorim, Suwon-si, Gyeonggi-do 16677 (KR); KI, Seokkan, Suwon-si, Gyeonggi-do 16677 (KR); AHN, Joseph, Suwon-si, Gyeonggi-do 16677 (KR); LEE, Haejin, Suwon-si, Gyeonggi-do 16677 (KR); LIM, Jonghyun, Suwon-si, Gyeonggi-do 16677 (KR); CHO, Hyeon, Suwon-si, Gyeonggi-do 16677 (KR)
(74) Representative: HGF
(86) International application number: PCT/KR2025/005807
(87) International publication number: WO 2025/230287

(57) **Abstract**

The disclosure relates to an electronic device. An electronic device according to an embodiment of the disclosure may comprise a housing, a printed circuit board disposed in the housing, an electrical component disposed on the printed circuit board, and a thermal conductor configured to exchange heat with the electrical component. The thermal conductor may include a first portion spaced apart from the printed circuit board, and a second portion extending from the first portion toward the printed circuit board, and disposed around the electrical component.

## Description

### [Technical Field]

Various embodiments of the disclosure relate to an electronic device, e.g., an electronic device including a thermal conductor.

### [Background Art]

Advancing information communication and semiconductor technologies accelerate the spread and use of various electronic devices. In particular, electronic devices are being developed to carry out communication while carried on.

The term "electronic device" may mean a device performing a particular function according to its equipped program, such as a home appliance, an electronic scheduler, a portable multimedia player, a mobile communication terminal, a tablet PC, a video/sound device, a desktop PC or laptop computer, a navigation device for use in an automobile, etc. For example, the electronic devices may output stored information as voices or images. As electronic devices are highly integrated, and as high-speed, high-volume wireless communication becomes commonplace, an electronic device, such as a mobile communication terminal, is recently being equipped with various functions. For example, an electronic device comes with the integrated functionality, including an entertainment function, such as playing video games, a multimedia function, such as replaying music/videos, a communication and security function, such as for mobile banking, a scheduling function or an e-wallet function. These electronic devices have been downsized to be conveniently carried by users.

The above-described information may be provided as related art for the purpose of helping understanding of the disclosure. No claim or determination is made as to whether any of the foregoing is applicable as background art in relation to the disclosure.

### [Disclosure of Invention]

### [Solution to Problems]

An electronic device according to an embodiment of the disclosure may comprise a housing, a printed circuit board disposed in the housing, an electrical component disposed on the printed circuit board, and a thermal conductor configured to exchange heat with the electrical component. The thermal conductor may include a first portion spaced apart from the printed circuit board, and a second portion extending from the first portion toward the printed circuit board, and disposed around the electrical component.

A thermal conductor according to an embodiment of the disclosure may comprise a first compound including a first molecule including hydrocarbon and a second molecule including styrene, and a 1-1th compound including the first molecule and the second molecule. A first weight ratio of the second molecule included in the first compound may be smaller than a 1-1th weight ratio of the second molecule included in the 1-1th compound.

A method for manufacturing a substrate assembly according to an embodiment of the disclosure may comprise disposing a shielding sheet, to which a thermal conductor is coupled, on a printed circuit board on which an electrical component is disposed, pressing the shielding sheet, to which the thermal conductor is coupled, toward the printed circuit board, and deforming the thermal conductor to surround the electrical component by compression.

### [Brief Description of Drawings]

The foregoing and other aspects, configurations, and/or advantages of an embodiment of the disclosure will be more apparent from the following detailed description taken in conjunction with the accompanying drawings.
FIG. 1 is a block diagram illustrating an electronic device in a network environment according to various embodiments;
FIG. 2 is a perspective view illustrating an electronic device according to an embodiment of the disclosure;
FIG. 3 is a perspective view illustrating an electronic device according to an embodiment of the disclosure;
FIG. 4 is an exploded perspective view illustrating an electronic device according to an embodiment of the disclosure;
FIG. 5 is an exploded perspective view illustrating an electronic device according to an embodiment of the disclosure;
FIG. 6 is a view illustrating a component of an electronic device according to an embodiment of the disclosure;
FIG. 7 is an exploded view illustrating a component according to an embodiment of the disclosure;
FIG. 8 is a side view illustrating a printed circuit board according to an embodiment of the disclosure;
FIG. 9 is a view illustrating an internal structure of a component of an electronic device according to an embodiment of the disclosure;
FIG. 10 is a view illustrating an internal structure of a component of an electronic device according to an embodiment of the disclosure;
FIG. 11 illustrates a state in which the compressed thermal conductor is separated from the receiving space.
FIG. 12 is a view illustrating a physical property value of a thermal conductor according to an embodiment of the disclosure;
FIG. 13 is a view illustrating a material included in a thermal conductor according to an embodiment of the disclosure;
FIG. 14 is a view illustrating a distribution of a material included in a thermal conductor according to an embodiment of the disclosure;
FIG. 15 is a view illustrating a thermal conductor according to an embodiment of the disclosure;
FIG. 16 is a view illustrating a shielding sheet according to an embodiment of the disclosure; and
FIG. 17 is a view illustrating an effect of a thermal conductor according to an embodiment of the disclosure.

Throughout the drawings, like reference numerals may be assigned to like parts, components, and/or structures.

### [Mode for the Disclosure]

The following description taken in conjunction with the accompanying drawings may provide an understanding of various exemplary implementations of the disclosure, including claims and their equivalents. The specific embodiments disclosed in the following description entail various specific details to aid understanding, but are regarded as one of various embodiments. Accordingly, it will be understood by those skilled in the art that various changes and modifications may be made to the various implementations described in the disclosure without departing from the scope and spirit of the disclosure. Further, descriptions of well-known functions and configurations may be omitted for clarity and brevity.

The terms and words used in the following description and claims are not limited to the bibliographical meaning, but may be used to clearly and consistently describe an embodiment of the disclosure. Therefore, it will be apparent to those skilled in the art that the following description of various implementations of the disclosure is provided only for the purpose of description, not for the purpose of limiting the disclosure defined as the scope of the claims and equivalent thereto.

The singular forms "a," "an," and "the" are intended to include the plural forms as well, unless the context clearly indicates otherwise. Thus, as an example, "a component surface" may be interpreted as including one or more of the surfaces of a component.

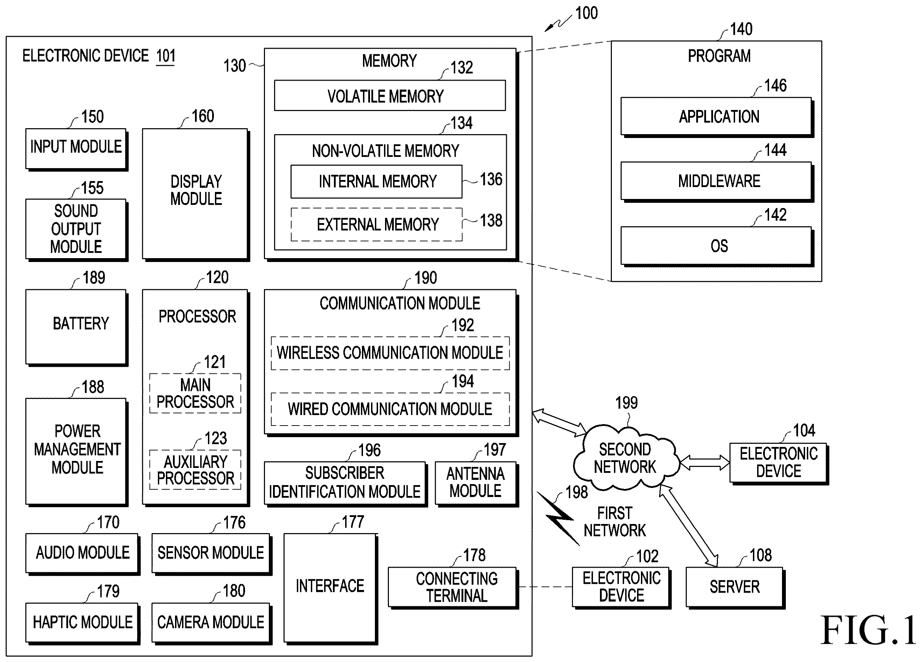

FIG. 1 is a block diagram illustrating an electronic device 101 in a network environment 100 according to various embodiments.

Referring to FIG. 1, the electronic device 101 in the network environment 100 may communicate with at least one of an electronic device 102 via a first network 198 (e.g., a short-range wireless communication network), or an electronic device 104 or a server 108 via a second network 199 (e.g., a long-range wireless communication network). According to an embodiment, the electronic device 101 may communicate with the electronic device 104 via the server 108. According to an embodiment, the electronic device 101 may include a processor 120, memory 130, an input module 150, a sound output module 155, a display module 160, an audio module 170, a sensor module 176, an interface 177, a connecting terminal 178, a haptic module 179, a camera module 180, a power management module 188, a battery 189, a communication module 190, a subscriber identification module (SIM) 196, or an antenna module 197. In an embodiment, at least one (e.g., the connecting terminal 178) of the components may be omitted from the electronic device 101, or one or more other components may be added in the electronic device 101. According to an embodiment, some (e.g., the sensor module 176, the camera module 180, or the antenna module 197) of the components may be integrated into a single component (e.g., the display module 160).

The processor 120 may execute, for example, software (e.g., a program 140) to control at least one other component (e.g., a hardware or software component) of the electronic device 101 coupled with the processor 120, and may perform various data processing or computation. According to one embodiment, as at least part of the data processing or computation, the processor 120 may store a command or data received from another component (e.g., the sensor module 176 or the communication module 190) in volatile memory 132, process the command or the data stored in the volatile memory 132, and store resulting data in non-volatile memory 134. According to an embodiment, the processor 120 may include a main processor 121 (e.g., a central processing unit (CPU) or an application processor (AP)), or an auxiliary processor 123 (e.g., a graphics processing unit (GPU), a neural processing unit (NPU), an image signal processor (ISP), a sensor hub processor, or a communication processor (CP)) that is operable independently from, or in conjunction with, the main processor 121. For example, when the electronic device 101 includes the main processor 121 and the auxiliary processor 123, the auxiliary processor 123 may be configured to use lower power than the main processor 121 or to be specified for a designated function. The auxiliary processor 123 may be implemented as separate from, or as part of the main processor 121.

The auxiliary processor 123 may control at least some of functions or states related to at least one component (e.g., the display module 160, the sensor module 176, or the communication module 190) among the components of the electronic device 101, instead of the main processor 121 while the main processor 121 is in an inactive (e.g., sleep) state, or together with the main processor 121 while the main processor 121 is in an active state (e.g., executing an application). According to an embodiment, the auxiliary processor 123 (e.g., an image signal processor or a communication processor) may be implemented as part of another component (e.g., the camera module 180 or the communication module 190) functionally related to the auxiliary processor 123. According to an embodiment, the auxiliary processor 123 (e.g., the neural processing unit) may include a hardware structure specified for artificial intelligence model processing. The artificial intelligence model may be generated via machine learning. Such learning may be performed, e.g., by the electronic device 101 where the artificial intelligence is performed or via a separate server (e.g., the server 108). Learning algorithms may include, but are not limited to, e.g., supervised learning, unsupervised learning, semi-supervised learning, or reinforcement learning. The artificial intelligence model may include a plurality of artificial neural network layers. The artificial neural network may be a deep neural network (DNN), a convolutional neural network (CNN), a recurrent neural network (RNN), a restricted Boltzmann machine (RBM), a deep belief network (DBN), a bidirectional recurrent deep neural network (BRDNN), deep Q-network or a combination of two or more thereof but is not limited thereto. The artificial intelligence model may, additionally or alternatively, include a software structure other than the hardware structure.

The memory 130 may store various data used by at least one component (e.g., the processor 120 or the sensor module 176) of the electronic device 101. The various data may include, for example, software (e.g., the program 140) and input data or output data for a command related thereto. The memory 130 may include the volatile memory 132 or the non-volatile memory 134.

The program 140 may be stored in the memory 130 as software, and may include, for example, an operating system (OS) 142, middleware 144, or an application 146.

The input module 150 may receive a command or data to be used by other component (e.g., the processor 120) of the electronic device 101, from the outside (e.g., a user) of the electronic device 101. The input module 150 may include, for example, a microphone, a mouse, a keyboard, keys (e.g., buttons), or a digital pen (e.g., a stylus pen).

The sound output module 155 may output sound signals to the outside of the electronic device 101. The sound output module 155 may include, for example, a speaker or a receiver. The speaker may be used for general purposes, such as playing multimedia or playing record. The receiver may be used for receiving incoming calls. According to an embodiment, the receiver may be implemented as separate from, or as part of the speaker.

The display module 160 may visually provide information to the outside (e.g., a user) of the electronic device 101. The display 160 may include, for example, a display, a hologram device, or a projector and control circuitry to control a corresponding one of the display, hologram device, and projector. According to an embodiment, the display 160 may include a touch sensor configured to detect a touch, or a pressure sensor configured to measure the intensity of a force generated by the touch.

The audio module 170 may convert a sound into an electrical signal and vice versa. According to an embodiment, the audio module 170 may obtain the sound via the input module 150, or output the sound via the sound output module 155 or a headphone of an external electronic device (e.g., an electronic device 102) directly (e.g., wiredly) or wirelessly coupled with the electronic device 101.

The sensor module 176 may detect an operational state (e.g., power or temperature) of the electronic device 101 or an environmental state (e.g., a state of a user) external to the electronic device 101, and then generate an electrical signal or data value corresponding to the detected state. According to an embodiment, the sensor module 176 may include, for example, a gesture sensor, a gyro sensor, an atmospheric pressure sensor, a magnetic sensor, an acceleration sensor, a grip sensor, a proximity sensor, a color sensor, an infrared (IR) sensor, a biometric sensor, a temperature sensor, a humidity sensor, or an illuminance sensor.

The interface 177 may support one or more specified protocols to be used for the electronic device 101 to be coupled with the external electronic device (e.g., the electronic device 102) directly (e.g., wiredly) or wirelessly. According to an embodiment, the interface 177 may include, for example, a high definition multimedia interface (HDMI), a universal serial bus (USB) interface, a secure digital (SD) card interface, or an audio interface.

A connecting terminal 178 may include a connector via which the electronic device 101 may be physically connected with the external electronic device (e.g., the electronic device 102). According to an embodiment, the connecting terminal 178 may include, for example, an HDMI connector, a USB connector, an SD card connector, or an audio connector (e.g., a headphone connector).

The haptic module 179 may convert an electrical signal into a mechanical stimulus (e.g., a vibration or motion) or electrical stimulus which may be recognized by a user via his tactile sensation or kinesthetic sensation. According to an embodiment, the haptic module 179 may include, for example, a motor, a piezoelectric element, or an electric stimulator.

The camera module 180 may capture a still image or moving images. According to an embodiment, the camera module 180 may include one or more lenses, image sensors, image signal processors, or flashes.

The power management module 188 may manage power supplied to the electronic device 101. According to an embodiment, the power management module 188 may be implemented as at least part of, for example, a power management integrated circuit (PMIC).

The battery 189 may supply power to at least one component of the electronic device 101. According to an embodiment, the battery 189 may include, for example, a primary cell which is not rechargeable, a secondary cell which is rechargeable, or a fuel cell.

The communication module 190 may support establishing a direct (e.g., wired) communication channel or a wireless communication channel between the electronic device 101 and the external electronic device (e.g., the electronic device 102, the electronic device 104, or the server 108) and performing communication via the established communication channel. The communication module 190 may include one or more communication processors that are operable independently from the processor 120 (e.g., the application processor (AP)) and supports a direct (e.g., wired) communication or a wireless communication. According to an embodiment, the communication module 190 may include a wireless communication module 192 (e.g., a cellular communication module, a short-range wireless communication module, or a global navigation satellite system (GNSS) communication module) or a wired communication module 194 (e.g., a local area network (LAN) communication module or a power line communication (PLC) module). A corresponding one of these communication modules may communicate with the external electronic device 104 via a first network 198 (e.g., a short-range communication network, such as Bluetooth^{™}, wireless-fidelity (Wi-Fi) direct, or infrared data association (IrDA)) or a second network 199 (e.g., a long-range communication network, such as a legacy cellular network, a 5G network, a next-generation communication network, the Internet, or a computer network (e.g., local area network (LAN) or wide area network (WAN)). These various types of communication modules may be implemented as a single component (e.g., a single chip), or may be implemented as multi components (e.g., multi chips) separate from each other. The wireless communication module 192 may identify or authenticate the electronic device 101 in a communication network, such as the first network 198 or the second network 199, using subscriber information (e.g., international mobile subscriber identity (IMSI)) stored in the subscriber identification module 196.

The wireless communication module 192 may support a 5G network, after a 4G network, and next-generation communication technology, e.g., new radio (NR) access technology. The NR access technology may support enhanced mobile broadband (eMBB), massive machine type communications (mMTC), or ultra-reliable and low-latency communications (URLLC). The wireless communication module 192 may support a high-frequency band (e.g., the mmWave band) to achieve, e.g., a high data transmission rate. The wireless communication module 192 may support various technologies for securing performance on a high-frequency band, such as, e.g., beamforming, massive multiple-input and multiple-output (massive MIMO), full dimensional MIMO (FD-MIMO), array antenna, analog beam-forming, or large scale antenna. The wireless communication module 192 may support various requirements specified in the electronic device 101, an external electronic device (e.g., the electronic device 104), or a network system (e.g., the second network 199). According to an embodiment, the wireless communication module 192 may support a peak data rate (e.g., 20Gbps or more) for implementing eMBB, loss coverage (e.g., 164dB or less) for implementing mMTC, or U-plane latency (e.g., 0.5ms or less for each of downlink (DL) and uplink (UL), or a round trip of 1ms or less) for implementing URLLC.

The antenna module 197 may transmit or receive a signal or power to or from the outside (e.g., the external electronic device). According to an embodiment, the antenna module 197 may include one antenna including a radiator formed of a conductor or conductive pattern formed on a substrate (e.g., a printed circuit board (PCB)). According to an embodiment, the antenna module 197 may include a plurality of antennas (e.g., an antenna array). In this case, at least one antenna appropriate for a communication scheme used in a communication network, such as the first network 198 or the second network 199, may be selected from the plurality of antennas by, e.g., the communication module 190. The signal or the power may then be transmitted or received between the communication module 190 and the external electronic device via the selected at least one antenna. According to an embodiment, other parts (e.g., radio frequency integrated circuit (RFIC)) than the radiator may be further formed as part of the antenna module 197.

According to various embodiments, the antenna module 197 may form a mmWave antenna module. According to an embodiment, the mmWave antenna module may include a printed circuit board, a RFIC disposed on a first surface (e.g., the bottom surface) of the printed circuit board, or adjacent to the first surface and capable of supporting a designated high-frequency band (e.g., the mmWave band), and a plurality of antennas (e.g., array antennas) disposed on a second surface (e.g., the top or a side surface) of the printed circuit board, or adjacent to the second surface and capable of transmitting or receiving signals of the designated high-frequency band.

At least some of the above-described components may be coupled mutually and communicate signals (e.g., commands or data) therebetween via an inter-peripheral communication scheme (e.g., a bus, general purpose input and output (GPIO), serial peripheral interface (SPI), or mobile industry processor interface (MIPI)).

According to an embodiment, instructions or data may be transmitted or received between the electronic device 101 and the external electronic device 104 via the server 108 coupled with the second network 199. The external electronic devices 102 or 104 each may be a device of the same or a different type from the electronic device 101. According to an embodiment, all or some of operations to be executed at the electronic device 101 may be executed at one or more of the external electronic devices 102, 104, or 108. For example, if the electronic device 101 should perform a function or a service automatically, or in response to a request from a user or another device, the electronic device 101, instead of, or in addition to, executing the function or the service, may request the one or more external electronic devices to perform at least part of the function or the service. The one or more external electronic devices receiving the request may perform the at least part of the function or the service requested, or an additional function or an additional service related to the request, and transfer an outcome of the performing to the electronic device 101. The electronic device 101 may provide the outcome, with or without further processing of the outcome, as at least part of a reply to the request. To that end, a cloud computing, distributed computing, mobile edge computing (MEC), or client-server computing technology may be used, for example. The electronic device 101 may provide ultra low-latency services using, e.g., distributed computing or mobile edge computing. In an embodiment, the external electronic device 104 may include an internet-of-things (IoT) device. The server 108 may be an intelligent server using machine learning and/or a neural network. According to an embodiment, the external electronic device 104 or the server 108 may be included in the second network 199. The electronic device 101 may be applied to intelligent services (e.g., smart home, smart city, smart car, or healthcare) based on 5G communication technology or IoT-related technology.

The electronic device according to various embodiments of the disclosure may be one of various types of electronic devices. The electronic devices may include, for example, a portable communication device (e.g., a smartphone), a computer device, a portable multimedia device, a portable medical device, a camera, a wearable device, or a home appliance. According to an embodiment of the disclosure, the electronic devices are not limited to those described above.

It should be appreciated that various embodiments of the disclosure and the terms used therein are not intended to limit the technological features set forth herein to particular embodiments and include various changes, equivalents, or replacements for a corresponding embodiment. With regard to the description of the drawings, similar reference numerals may be used to refer to similar or related elements. It is to be understood that a singular form of a noun corresponding to an item may include one or more of the things, unless the relevant context clearly indicates otherwise. As used herein, each of such phrases as "A or B," "at least one of A and B," "at least one of A or B," "A, B, or C," "at least one of A, B, and C," and "at least one of A, B, or C," may include all possible combinations of the items enumerated together in a corresponding one of the phrases. As used herein, such terms as "1st" and "2nd," or "first" and "second" may be used to simply distinguish a corresponding component from another, and does not limit the components in other aspect (e.g., importance or order). It is to be understood that if an element (e.g., a first element) is referred to, with or without the term "operatively" or "communicatively", as "coupled with," "coupled to," "connected with," or "connected to" another element (e.g., a second element), it means that the element may be coupled with the other element directly (e.g., wiredly), wirelessly, or via a third element.

As used herein, the term "module" may include a unit implemented in hardware, software, or firmware, and may interchangeably be used with other terms, for example, "logic," "logic block," "part," or "circuitry". A module may be a single integral component, or a minimum unit or part thereof, adapted to perform one or more functions. For example, according to an embodiment, the module may be implemented in a form of an application-specific integrated circuit (ASIC).

Various embodiments as set forth herein may be implemented as software (e.g., the program 140) including one or more instructions that are stored in a storage medium (e.g., internal memory 136 or external memory 138) that is readable by a machine (e.g., the electronic device 101). For example, a processor (e.g., the processor 120) of the machine (e.g., the electronic device 101) may invoke at least one of the one or more instructions stored in the storage medium, and execute it, with or without using one or more other components under the control of the processor. This allows the machine to be operated to perform at least one function according to the at least one instruction invoked. The one or more instructions may include a code generated by a complier or a code executable by an interpreter. The storage medium readable by the machine may be provided in the form of a non-transitory storage medium. Wherein, the term "non-transitory" simply means that the storage medium is a tangible device, and does not include a signal (e.g., an electromagnetic wave), but this term does not differentiate between where data is semipermanently stored in the storage medium and where the data is temporarily stored in the storage medium.

According to an embodiment, a method according to various embodiments of the disclosure may be included and provided in a computer program product. The computer program products may be traded as commodities between sellers and buyers. The computer program product may be distributed in the form of a machine-readable storage medium (e.g., compact disc read only memory (CD-ROM)), or be distributed (e.g., downloaded or uploaded) online via an application store (e.g., Play Store^{™}), or between two user devices (e.g., smart phones) directly. If distributed online, at least part of the computer program product may be temporarily generated or at least temporarily stored in the machine-readable storage medium, such as memory of the manufacturer's server, a server of the application store, or a relay server.

According to various embodiments, each component (e.g., a module or a program) of the above-described components may include a single entity or multiple entities. Some of the plurality of entities may be separately disposed in different components. According to various embodiments, one or more of the above-described components may be omitted, or one or more other components may be added. Alternatively or additionally, a plurality of components (e.g., modules or programs) may be integrated into a single component. In such a case, according to various embodiments, the integrated component may still perform one or more functions of each of the plurality of components in the same or similar manner as they are performed by a corresponding one of the plurality of components before the integration. According to various embodiments, operations performed by the module, the program, or another component may be carried out sequentially, in parallel, repeatedly, or heuristically, or one or more of the operations may be executed in a different order or omitted, or one or more other operations may be added.

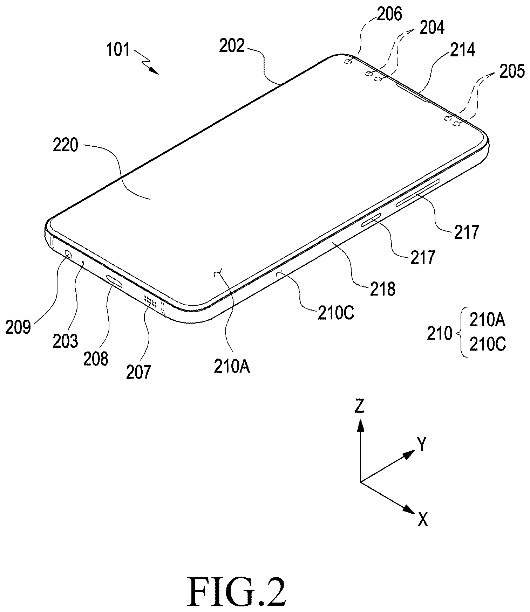

FIG. 2 is a front perspective view illustrating an electronic device according to an embodiment of the disclosure.

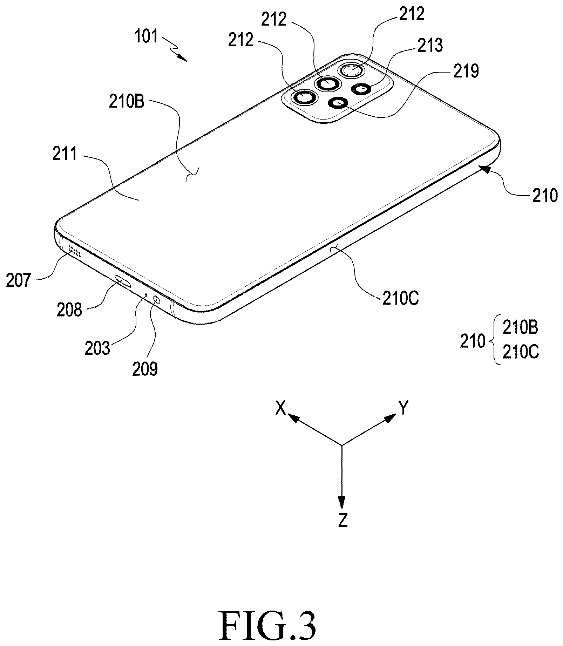

FIG. 3 is a rear perspective view illustrating an electronic device according to an embodiment of the disclosure.

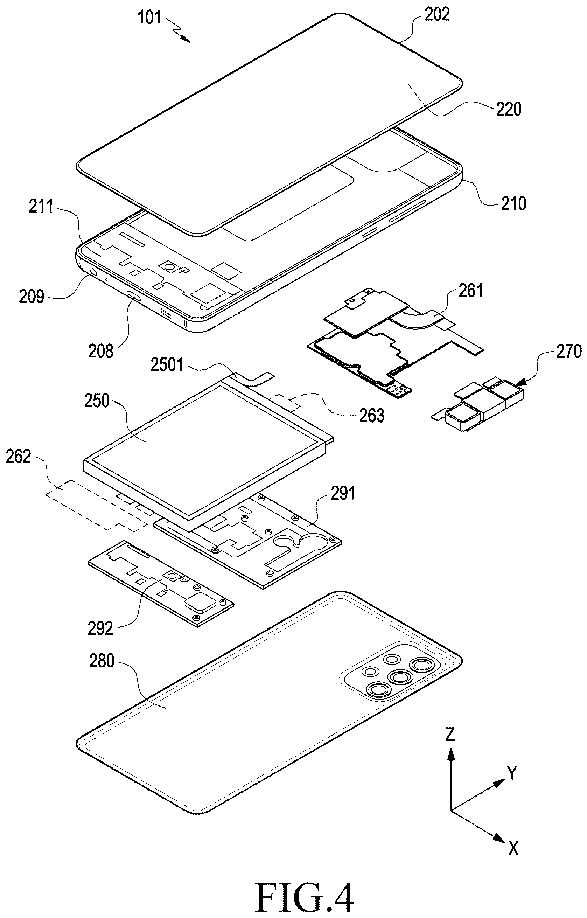

The embodiments of FIGS. 2 and 3 may be combined with the embodiment of FIG. 1 or the embodiments of FIGS. 4 to 17.

Referring to FIGS. 2 and 3, according to an embodiment, an electronic device 101 (e.g., the electronic device 101 of FIG. 1) may include a housing 210 including a first surface (or front surface) 210A, a second surface (or rear surface) 210B, and a side surface 210C surrounding a space between the first surface 210A and the second surface 210B. According to an embodiment (not illustrated), the housing 210 may denote a structure forming the first surface 210A of FIG. 2, the second surface 210B of FIG. 3, and some of the side surfaces 210C. According to an embodiment, at least part of the first surface 210A may have a substantially transparent front plate 202 (e.g., a glass plate or polymer plate including various coat layers). The second surface 210B may be formed by a rear plate 211 that is substantially opaque. The rear plate 211 may be formed of, e.g., laminated or colored glass, ceramic, polymer, metal (e.g., aluminum, stainless steel (STS), or magnesium), or a combination of at least two thereof. The rear plate 211 may form the second surface 210B. The side surface 210C may be formed by a side structure (or "side bezel structure") 218 that couples to the front plate 202 and the rear plate 211 and includes a metal and/or polymer. In an embodiment, the rear plate 211 and the side structure 218 may be integrally formed together and include the same material (e.g., a metal, such as aluminum).

Although not shown, the front plate 202 may include area(s) that bend from at least a portion of an edge toward the rear plate 211 and seamlessly extend. In an embodiment, only one of the areas of the front plate 202 (or the rear plate 211), which bend to the rear plate 211 (or front plate 202) and extend may be included in one edge of the first surface 210A. According to an embodiment, the front plate 202 or the rear plate 211 may have a substantially flat plate shape. For example, no bent and extended area may be included. When an area bending and extending is included, the thickness of the electronic device 101 at the portion including the area bending and extending may be smaller than the thickness of the rest.

According to an embodiment, the electronic device 101 may include at least one or more of a display 220, audio modules 203, 207, and 214, sensor modules 204 and 219, camera modules 205, 212, and 213, key input devices 217, a light emitting device 206, and connector holes 208 and 209. In an embodiment, the electronic device 101 may exclude at least one (e.g., the key input device 217 or the light emitting device 206) of the components or may add other components.

The display 220 may be visually exposed through a significant portion of the front plate 202. In an embodiment, at least a portion of the display 220 may be visually exposed through the front plate 202 forming the first surface 210A, or through a portion of the side surface 210C. In an embodiment, the edge of the display 220 may be formed to be substantially the same in shape as an adjacent outer edge of the front plate 202. In an embodiment (not illustrated), the interval between the outer edge of the display 220 and the outer edge of the front plate 202 may remain substantially even to give a larger area of visual exposure of the display 220.

In an embodiment (not shown), the screen display region of the display 220 may have a recess or opening in a portion thereof, and at least one or more of the audio module 214, sensor module 204, camera module 205, and light emitting device 206 may be aligned with the recess or opening. In an embodiment (not shown), at least one or more of the audio module 214, sensor module 204, camera module 205, fingerprint sensor (not shown), and light emitting device 206 may be included on the rear surface of the screen display area of the display 220. In an embodiment (not illustrated), the display 220 may be disposed to be coupled with, or adjacent, a touch detecting circuit, a pressure sensor capable of measuring the strength (pressure) of touches, and/or a digitizer for detecting a magnetic field-type stylus pen.

The audio modules 203, 207, and 214 may include a microphone hole 203 and speaker holes 207 and 214. A microphone for acquiring external sounds may be disposed in the microphone hole 203. In an embodiment, a plurality of microphones may be disposed to detect the direction of the sound. The speaker holes 207 and 214 may include an external speaker hole 207 and a phone receiver hole 214. In an embodiment, the speaker holes 207 and 214 and the microphone hole 203 may be implemented as a single hole, or speakers may be rested without the speaker holes 207 and 214 (e.g., piezo speakers).

The sensor modules 204 and 219 may generate an electrical signal or data value corresponding to an internal operating state or external environmental state of the electronic device 101. For example, the sensor modules 204 and 219 may include a first sensor module 204 (e.g., a proximity sensor) and/or a second sensor module (not shown) (e.g., a fingerprint sensor), which is disposed on the first surface 210A of the housing 210, and/or a third sensor module 219 and/or a fourth sensor module (e.g., a fingerprint sensor) disposed on the second surface 210B of the housing 210. The fingerprint sensor may be disposed on the second surface 210B or side surface 210C as well as the first surface 210A (e.g., the display 220) of the housing 210. The electronic device 101 may further include, e.g., at least one of a gesture sensor, a gyro sensor, an atmospheric pressure sensor, a magnetic sensor, an acceleration sensor, a grip sensor, a color sensor, an infrared (IR) sensor, a biometric sensor, a temperature sensor, a humidity sensor, or an illuminance sensor.

The camera modules 205, 212, and 213 may include a first camera device 205 disposed on the first surface 210A of the electronic device 101, and a second camera device 212 and/or a flash 213 disposed on the second surface 210B. The camera devices 205 and 212 may include one or more lenses, an image sensor, and/or an image signal processor. The flash 213 may include, e.g., a light emitting diode (LED) or a xenon lamp. In an embodiment, two or more lenses (an infrared (IR) camera, a wide-angle lens, and a telescopic lens) and image sensors may be disposed on one surface of the electronic device 101. In an embodiment, flash 213 may emit infrared light. The infrared light emitted by the flash 213 and reflected by the subject may be received through the third sensor module 219. The electronic device 101 or the processor of the electronic device 101 may detect depth information about the subject based on the time point when the infrared light is received from the third sensor module 219.

The key input device 217 may be disposed on the side surface 210C of the housing 210. In an embodiment, the electronic device 101 may exclude all or some of the above-mentioned key input devices 217 and the excluded key input devices 217 may be implemented in other forms, e.g., as soft keys, on the display 220. In an embodiment, the key input device may include the sensor module disposed on the second surface 210B of the housing 210.

The light emitting device 206 may be disposed on, e.g., the first surface 210A of the housing 210. The light emitting device 206 may provide, e.g., information about the state of the electronic device 101 in the form of light. In an embodiment, the light emitting device 206 may provide a light source that interacts with, e.g., the camera module 205. The light emitting device 206 may include, e.g., a light emitting diode (LED), an infrared (IR) LED, or a xenon lamp.

The connector holes 208 and 209 may include a first connector hole 208 for receiving a connector (e.g., a universal serial bus (USB) connector) for transmitting or receiving power and/or data to/from an external electronic device and/or a second connector hole 209 (e.g., an earphone jack) for receiving a connector for transmitting or receiving audio signals to/from the external electronic device.

FIG. 4 is a front exploded perspective view illustrating the electronic device of FIG. 2 according to an embodiment of the disclosure.

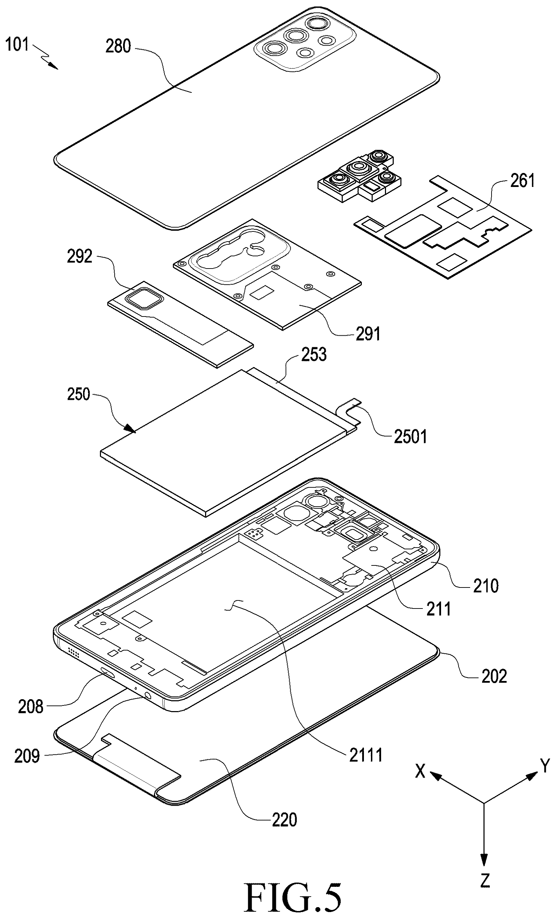

FIG. 5 is an exploded perspective view illustrating a rear surface of the electronic device of FIG. 3 according to an embodiment of the disclosure.

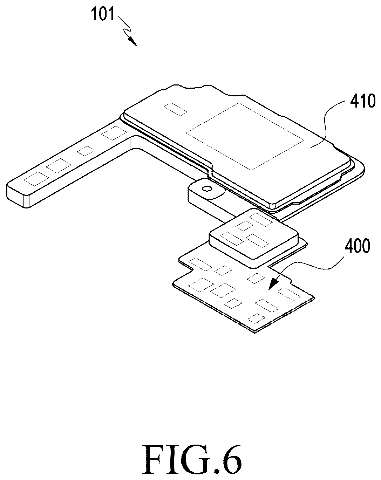

The embodiments of FIGS. 4 to 5 may be combined with the embodiments of FIGS. 6 to 17.

Referring to FIGS. 4 and 5, an electronic device 101 may include a side structure 218, a first supporting member 211 (e.g., a bracket), a front plate 202, a display 220, at least one printed circuit board (or substrate assembly) 261 and 262, a battery 250, a second supporting member 291 and 292 (e.g., a rear case), an antenna, a camera assembly, and a rear plate 280. When the plurality of printed circuit boards 261 and 262 are included, the electronic device 101 may include at least one flexible printed circuit board 263 to electrically connect different printed circuit boards. For example, the printed circuit boards 261 and 262 may include a first circuit board 261 disposed above the battery 250 (e.g., in the +Y-axis direction) and a second circuit board 262 disposed under the first circuit board 261 (e.g., in the -Y-axis direction), and the flexible printed circuit board 263 may electrically connect the first circuit board 261 and the second circuit board 262.

According to an embodiment, the electronic device 101 may exclude at least one (e.g., the first supporting member 211 or the second supporting member 291 and 292) of the components or may add other components. At least one of the components of the electronic device 101 may be the same or similar to at least one of the components of the electronic device 101 of FIG. 1 and no duplicate description is made below.

At least a portion of the first supporting member 211 may be provided in a flat plate shape. In an embodiment, the first supporting member 211 may be disposed inside the electronic device 101 to be connected with the side structure 218 or integrated with the side structure 218. The first supporting member 211 may be formed of, e.g., a metal and/or non-metallic material (e.g., polymer). When the first supporting member 211 is at least partially formed of a metallic material, a portion of the side structure 218 or the first supporting member 211 may function as an antenna. The display 230 may be coupled to one surface of the first supporting member 211, and the printed circuit board 261 and 262 may be coupled to the opposite surface of the first supporting member 211. A processor, memory, and/or interface may be mounted on the printed circuit board 261 and 262. The processor may include one or more of, e.g., a central processing unit, an application processor, a graphic processing device, an image signal processing, a sensor hub processor, or a communication processor.

According to an embodiment, the housing 210 may include a first supporting member 211 and a side structure 218. According to an embodiment, the housing 210 may be understood as a structure for receiving, protecting, or disposing the printed circuit boards 261 and 262 or the battery 250. In an embodiment, the housing 210 may be understood as including a structure that the user may visually or tactfully recognize from the exterior of the electronic device 101, e.g., the side structure 218, the front plate 202, and/or the rear plate 280. For example, the housing 210 may include structures (e.g., the side structure 218218, the front plate 202, and the rear plate 280) forming the appearance of the electronic device 101. In an embodiment, the first supporting member 211 may be disposed between the front plate 202 and the rear plate 280 and may function as a structure for placing an electrical/electronic component, such as the printed circuit boards 261 and 262 or the camera assembly.

The memory may include, e.g., a volatile or non-volatile memory.

The interface may include, e.g., a high definition multimedia interface (HDMI), a universal serial bus (USB) interface, a secure digital (SD) card interface, and/or an audio interface. The interface may electrically or physically connect, e.g., the electronic device 101 with an external electronic device and may include a USB connector, an SD card/multimedia card (MMC) connector, or an audio connector.

The second supporting member 291 or 292 may include, e.g., an upper supporting member 291 or a lower supporting member 292. In an embodiment, the upper supporting member 291, together with a portion of the first supporting member 211, may be disposed to surround the printed circuit boards 261 and 262 (e.g., the first circuit board 261). For example, the upper supporting member 291 of the second supporting members 291 and 292 may be disposed to face the first supporting member 211 with the first circuit board 261 interposed therebetween. In an embodiment, the lower supporting member 292 of the second supporting members 291 and 292 may face the first supporting member 211 with the second circuit board 262 interposed therebetween. A circuit device (e.g., a processor, a communication module, or memory) implemented in the form of an integrated circuit chip or various electrical/electronic components may be disposed on the printed circuit boards 261 and 262. According to an embodiment, the printed circuit boards 261 and 262 may receive an electromagnetic shielding environment from the second supporting member 291 and 292. In an embodiment, the lower supporting member 292 may be utilized as a structure in which electrical/electronic components, such as a speaker module, or an interface (e.g., a USB connector, an SD card/MMC connector, or an audio connector) may be disposed. In an embodiment, electrical/electronic components, such as a speaker module and an interface (e.g., a USB connector, an SD card/MMC connector, or an audio connector) may be disposed on an additional printed circuit board (not shown). For example, the lower supporting member 292, together with another portion of the first supporting member 211, may be disposed to surround an additional printed circuit board (e.g., the second printed circuit board 262). The speaker module or interface disposed on the additional printed circuit board (not shown) or the lower supporting member 292 may be disposed corresponding to the audio module 207 or connector holes 208 and 309 of FIG. 2.

The battery 250 may be a device for supplying power to at least one component of the electronic device 101. The battery 450 may include, e.g., a primary cell which is not rechargeable, a secondary cell which is rechargeable, or a fuel cell. At least a portion of the battery 250 may be disposed on substantially the same plane as the printed circuit board 261 and 262. The battery 250 may be integrally or detachably disposed inside the electronic device 101.

Although not shown, the antenna may include a conductor pattern implemented on the surface of the second supporting member 291 and 292 through, e.g., laser direct structuring. In an embodiment, the antenna may include a printed circuit pattern formed on the surface of the thin film. The thin film-type antenna may be disposed between the rear plate 280 and the battery 250. The antenna may include, e.g., a near-field communication (NFC) antenna, a wireless charging antenna, and/or a magnetic secure transmission (MST) antenna. The antenna may perform short-range communication with, e.g., an external device or may wirelessly transmit or receive power necessary for charging. In an embodiment of the disclosure, another antenna structure may be formed by a portion or combination of the side structure 218 and/or the first supporting member 211.

According to an embodiment, the first supporting member 211 may include an accommodation portion 2111. The battery 250 may be disposed in the accommodation portion 2111. The battery 250 may include a terrace 253. The terrace 253 may protrude toward the printed circuit board 261 and 262. The battery 250 may include a battery connection member 2501 connecting the terrace 253 and the printed circuit board 261 and 262.

According to an embodiment, the electronic device 101 may include a connector hole 208. The connector hole 208 may be open in a portion of the housing 210. The connector hole 208 may communicate with an outer space of the housing 210. The electronic device 101 may be connected to an external device (e.g., a USB port, a charging line, or the like), and the external device may be inserted into the connector hole 208.

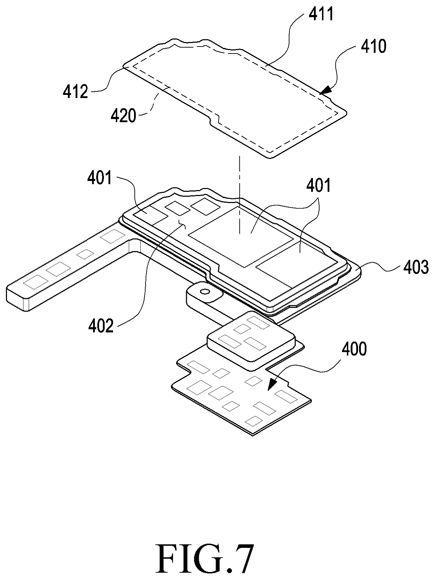

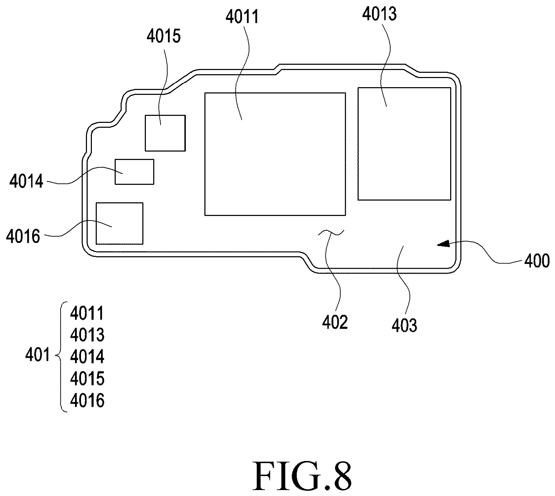

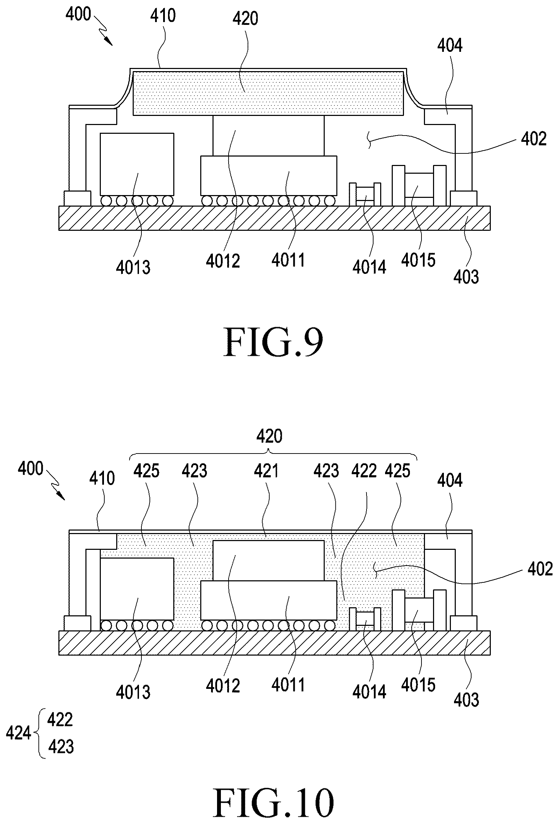

FIG. 6 is a view illustrating a substrate assembly 400 of an electronic device 101. FIG. 7 is an exploded view illustrating the substrate assembly 400 of FIG. 6. FIG. 8 is a view illustrating components of a substrate assembly 400. The components described with reference to FIGS. 6 to 8 may be identical in whole or part to the components described with reference to FIGS. 1 to 5. Some or all of the components described with reference to FIGS. 6 to 8 may be the same as all or some of the components described with reference to FIGS. 9 to 17.

According to an embodiment, the electronic device 101 may include a substrate assembly 400. The substrate assembly 400 may be disposed in the housing (e.g., the housing 301 of FIGS. 4 and 5). The description of the printed circuit boards 340a and 340b made with reference to FIGS. 1 to 5 may be equally applied to the description of the substrate assembly 400. The substrate assembly 400 may include a printed circuit board (e.g., the printed circuit board 340a of FIG. 5).

According to an embodiment, the substrate assembly 400 may include a printed circuit board 403. The description of the printed circuit board 340a made with reference to FIGS. 1 to 5 may be equally applied to the description of the printed circuit board 403.

According to an embodiment, the substrate assembly 400 may include a shielding sheet 410. The shielding sheet 410 may be disposed on one side of the printed circuit board 403. The shielding sheet 410 may cover the electrical components 401.

According to an embodiment, the substrate assembly 400 may include an electrical component 401. The electrical component 401 may be disposed on the printed circuit board 403. The electrical component 401 may include a plurality of electrical components 4011, 4013, 4014, 4015, and 4016.

According to an embodiment, the substrate assembly 400 may include a receiving space 402. The electrical component 401 may be disposed in the receiving space 402. The plurality of electrical components 401 may be spaced apart from each other, and the receiving space 402 may be formed between the plurality of electrical components 401.

According to an embodiment, the shielding sheet 410 may cover the electrical component 401. The shielding sheet 410 may cover the receiving space 402. The shielding sheet 410 may seal the receiving space 402. The shielding sheet 410 may be spaced apart from the printed circuit board 403. The receiving space 402 may be formed between the shielding sheet 410 and the printed circuit board 403. The electrical component 401 may be disposed between the shielding sheet 410 and the printed circuit board 403. The shielding sheet 410 may be referred to as a "shielding cover" or a "shielding film".

According to an embodiment, the electronic device 101 may include a thermal conductor 420. The thermal conductor 420 may be configured to transfer heat generated by the substrate assembly 400. The thermal conductor 420 may discharge heat generated from the substrate assembly 400 to the outside of the substrate assembly 400. The thermal conductor 420 may conduct heat generated from the substrate assembly 400 to the shielding sheet 410. The shielding sheet 410 may conduct heat from the thermal conductor 420 to or towards the housing 210. The housing 210 may conduct heat from the thermal conductor 420 and/or the shielding sheet 410 to an outside of the electronic device 101. The thermal conductor 420 may be referred to as a "heat transfer member". The thermal conductor 420 may be referred to as a "heat dissipation element". The thermal conductor 420 may be referred to as a "heat sink". The thermal conductor 420 may be referred to as a "heat dissipation member".

According to an embodiment, the thermal conductor 420 may be coupled to the shielding sheet 410. The thermal conductor 420 may be adhered to the shielding sheet 410. For example, the thermal conductor 420 may include an adhesive material and may be adhered to the shielding sheet 410. The thermal conductor 420 may include a thermal interface material (TIM). The shielding sheet 410 may include a first surface 411 and a second surface 412. The first surface 411 may be a surface facing the outside of the substrate assembly 400. The second surface 412 may be a surface facing the inside of the substrate assembly 400. The second surface 412 may face the electrical component 401. The second surface 412 may face the receiving space 402. The thermal conductor 420 may be coupled to the second surface 412.

According to an embodiment, the thermal conductor 420 may be disposed to surround the electrical component 401. The thermal conductor 420 may be disposed to be able to exchange heat with the electrical component 401. The thermal conductor 420 may be disposed in the receiving space 402.

According to an embodiment, the electrical component 401 may be mounted on the printed circuit board 403. The electrical component 401 may be disposed on the printed circuit board 403. The electrical component 401 may be disposed in the receiving space 402. The electrical component 401 may be disposed between the printed circuit board 403 and the shielding sheet 410.

According to an embodiment, the electrical component 401 may include a plurality of electrical components 4011, 4013, 4014, 4015, and 4016. The electrical component 401 may include at least one processor 4011. At least one processor 4011 may be disposed on the printed circuit board 403. The description of the processor 120 described with reference to FIG. 1 may be identically applied to the description of the at least one processor 4011.

According to an embodiment, the electrical component 401 may include memory (e.g., the memory 4012 of FIG. 9). The memory 4012 may be electrically connected to at least one processor 4011. The memory 4012 may be stacked with at least one processor 4011. The description of the memory 130 described with reference to FIG. 1 may be identically applied to the description of the memory 4012.

According to an embodiment, the electrical component 401 may include second memory 4013. The second memory 4013 may be electrically connected to at least one processor 4011. The electrical component 401 may include electrical elements 4014, 4015, and 4016. The electrical elements 4014, 4015, and 4016 may be disposed on the printed circuit board 403. The electrical elements 4014, 4015, and 4016 may be spaced apart from at least one processor 4011. For example, the electrical element may be an area in which an integrated circuit or a plurality of circuit elements (e.g., coils, condensers, resistors, capacitors, or transistors) disposed densely to perform a predetermined function (e.g., communication) are densely disposed.

According to an embodiment, the thermal conductor 420 may discharge heat generated from the electrical component 401 to the outside of the substrate assembly 400. The thermal conductor 420 may be disposed between the printed circuit board 403 and the shielding sheet 410 and may fill at least a portion of the receiving space 402.

FIG. 9 is a view conceptually illustrating an internal structure of a substrate assembly 400. FIG. 9 may be a view illustrating an internal structure at one moment in the process of assembling the substrate assembly 400. Some or all of the components described with reference to FIG. 9 may be the same as all or some of the components described with reference to FIGS. 1 to 8. Some or all of the components described with reference to FIG. 9 may be the same as all or some of the components described with reference to FIGS. 10 to 17.

According to an embodiment, the substrate assembly 400 may include a printed circuit board 403. The electrical components 4011, 4012, 4013, 4014, and 4015 may be disposed on the printed circuit board 403.

According to an embodiment, the substrate assembly 400 may include a shield can 404. The shield can 404 may be coupled to the printed circuit board 403. The shield can 404 may surround the electrical components 4011, 4012, 4013, 4014, and 4015. The receiving space 402 may be disposed in the shield can 404.

According to an embodiment, the shielding sheet 410 may be coupled to the shield can 404. The shielding sheet 410 and the shield can 404 may limit the receiving space 402. The shielding sheet 410 may cover the electrical components 4011, 4012, 4013, 4014, and 4015 disposed inside the shield can 404. The shielding sheet 410 and the shield can 404 may minimize leakage of the magnetic field generated from the electrical component 401 disposed in the receiving space 402 to the outside, or minimize inflow of the magnetic field from the outside.

According to an embodiment, the thermal conductor 420 may be coupled to the shielding sheet 410. The thermal conductor 420 may move toward the receiving space 402 together with the shielding sheet 410. The thermal conductor 420 may include a deformable material. The thermal conductor 420 may be compressed by the shielding sheet 410 and permeated into the receiving space 402.

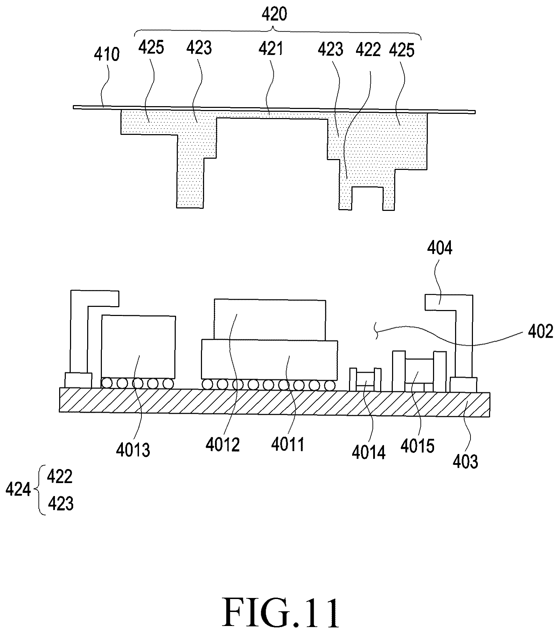

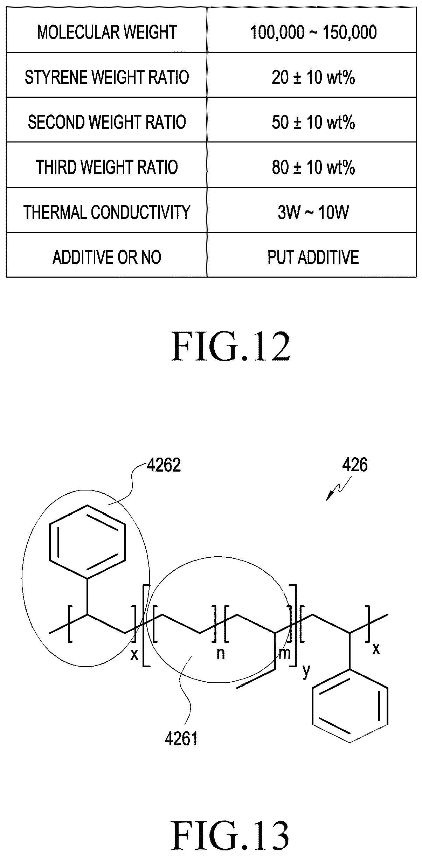

FIG. 10 is a view conceptually illustrating an internal structure of a substrate assembly 400. FIG. 10 may be a view illustrating an internal structure after the assembly of the substrate assembly 400 is completed. FIG. 11 illustrates a state in which the compressed thermal conductor 420 is separated from the receiving space 402. FIG. 11 illustrates the shielding sheet 410 is separated from the receiving space 402 together with the thermal conductor 420 when the thermal conductor 420 is in a hardened state (e.g., solid state). Some or all of the components described with reference to FIG. 10 may be the same as all or some of the components described with reference to FIGS. 1 to 9. Some or all of the components described with reference to FIG. 10 may be the same as those described with reference to FIGS. 12 to 17.

According to an embodiment, the thermal conductor 420 may move into the receiving space 402 together with the shielding sheet 410. The thermal conductor 420 may include a material having compressibility. The thermal conductor 420 may include a material having elasticity. The thermal conductor 420 may include a deformable material. The thermal conductor 420 may be compressed to fill the inside of the receiving space 402. The thermal conductor 420 may be deformed toward the inside of the receiving space 402. The thermal conductor 420 may fill a space between the electrical components 4011, 4012, 4013, 4014, and 4015. The thermal conductor 420 may extend from the shielding sheet 410 to the printed circuit board 403. The thermal conductor 420 may be compressed in the state of FIG. 9 to be deformed to the printed circuit board 403 as shown in FIG. 10.

According to an embodiment, the thermal conductor 420 may be separated from the receiving space 402 without substantial deformation from its compressed form as shown in FIG. 11. As an example, when the shielding sheet 410 and the thermal conductor 420 are separated from the receiving space 402, the electrical components 4011, 4012, 4013, 4014, and 4015 exposed to an outside of the substrate assembly 400 can be repaired. Since the thermal conductor 420 maintains its compressed form, as shown in FIG. 11, the thermal conductor 420 may be reassembled (or reused) to cover the electrical components 4011, 4012, 4013, 4014, and 4015. After reassembly of the thermal conductor 420, the electrical components 4011, 4012, 4013, 4014, and 4015 may generate heat. Then, the thermal conductor 420 may absorb the heat and may then be softened. The softened thermal conductor 420 may adhere to the electrical components 4011, 4012, 4013, 4014, and 4015.

According to an embodiment, the thermal conductor 420 may include a first portion 421. The first portion 421 may be coupled to the shielding sheet 410. The first portion 421 may be disposed between the shielding sheet 410 and the electrical component 4012. The first portion 421 may be disposed between the shielding sheet 410 and the memory 4012.

According to an embodiment, the thermal conductor 420 may include a second portion 424. The second portion 424 may extend from the first portion 421 toward the printed circuit board 403. The second portion 424 may fill the receiving space 402. The second portion 424 may be disposed inside the shield can 404. The second portion 424 may be disposed between the electrical components 4011, 4012, 4013, 4014, and 4015.

According to an embodiment, the second portion 424 may include a first conduction portion 422. The first conduction portion 422 may be disposed at a position corresponding to the processor 4011. The first conduction portion 422 may be positioned between the processor 4011 and the shield can 404. Heat generated by the processor 4011 may be conducted to the first conduction portion 422.

According to an embodiment, the second portion 424 may include a second conduction portion 423. The second conduction portion 423 may be disposed at a position corresponding to the memory 4012. The second conduction portion 423 may be positioned between the memory 4012 and the shield can 404. Heat generated from the memory 4012 may be conducted to the second conduction portion 423.

According to an embodiment, the first portion 421 and the second portion 424 may be integrated. The first conduction portion 422 and the second conduction portion 423 may be integrally formed.

According to an embodiment, the thermal conductor 420 may include an extended portion 425. The extended portion 425 may fill the inside of the receiving space 402. The extended portion 425 may extend from the first portion 421 toward the shield can 404. The extended portion 425 may extend from the second portion 424 toward the shield can 404.

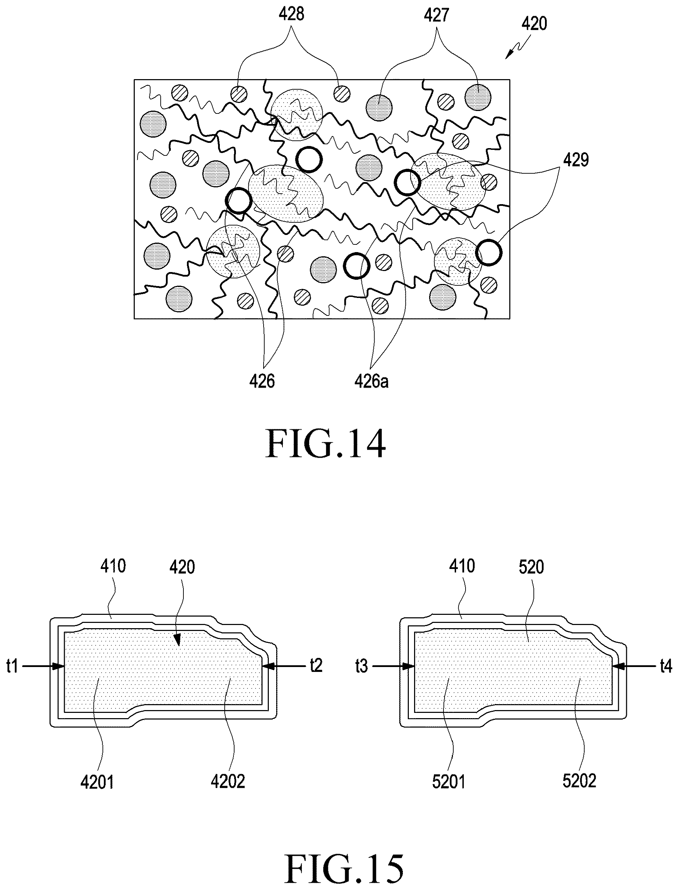

FIG. 12 is a table illustrating physical property values of materials included in a thermal conductor 420 according to an embodiment of the disclosure. FIG. 13 is a chemical structure formula of one of the materials included in the thermal conductor 420 according to an embodiment of the disclosure. FIG. 14 is a view conceptually illustrating a distribution of materials included in a thermal conductor 420 according to an embodiment of the disclosure. Some or all of the components described with reference to FIGS. 12 to 14 may be the same as the components described with reference to FIGS. 1 to 10. Some or all of the components described with reference to FIGS. 12 to 14 may be the same as all or some of the components described with reference to FIGS. 15 to 17.

According to an embodiment, the thermal conductor 420 may include compounds (e.g., compounds 426, 426a, 427, 428, and 429 of FIG. 14). The thermal conductor 420 may include a mixture of compounds 426, 426a, 427, 428, and 429.

According to an embodiment, the thermal conductor 420 may include a first compound 426. The first compound 426 may include a polymer material. The first compound 426 may include a styrene-b-(ethylene-co-butylene)-b-styrene (SEBS) material.

According to an embodiment, the thermal conductor 420 may include a 1-1th compound 426a. The 1-1th compound 426a may include a polymer material. The 1-1th compound 426a may include a styrene-b-(ethylene-co-butylene)-b-styrene (SEBS) material. The weight ratio (e.g., 1-1th weight ratio) of the styrene molecule in the 1-1th compound 426a may be different from the weight ratio (e.g., first weight ratio) of the styrene molecule in the first compound 426.

According to an embodiment, the thermal conductor 420 may include a second compound 427. The second compound 427 may include a polymer material. The second compound 427 may include a phase change material (PCM) material. The second compound 427 may include at least one of paraffin wax, paraffin oil, or a carboxylic acid salt material. The thermal conductor 420 including the second compound 427 may be in a solid phase at room temperature (e.g., 25 degrees Celsius). The thermal conductor 420 including the second compound 427 may be configured to be at least partially changed into gel phase by heat generated during the operation of the electrical component 401.

According to an embodiment, the thermal conductor 420 may include a filler 428. The filler 428 may include a compound. The filler 428 is configured to transfer heat. The filler 428 may include at least one of aluminum oxide (Al2O3), AIN, CNT, graphene, or magnesium oxide (MgO). The filler 428 may be referred to as a heat dissipation material.

According to an embodiment, the thermal conductor 420 may include an additive 429. The additive 429 may surround surfaces of the filler 428. The additive 429 may form a film on the surfaces of the filler 428. The additive 429 may increase the degree of dispersion of the filler 428. As an example, the additive 429 may be a surfactant. For example, the filler 428 coated with the additive 429 (e.g., the surfactant) may be obtained by mixing the additive 429 with the filler 428, followed by stirring a mixture of the filler 428 and the additive 429.

According to an embodiment, the filler 428 coated with the additive 429 may enhance the compressibility of the thermal conductor 420. The styrene blocks may exhibit aggregation behavior within the thermal conductor 420. The aggregation may occur due to the similarity in polarity of the styrene blocks (e.g., hydrophobicity). The filler 428 coated with the additive 429 may reduce the degree of aggregation of the styrene blocks. For example, the filler 428 coated with the additive 429 may disperse into the regions where the styrene blocks are aggregated. As a result, the degree of aggregation of the styrene blocks may decrease. Since the aggregation of the styrene blocks can reduce the softness of the thermal conductor 420, the compressibility of the thermal conductor 420 may be improved when the aggregation of the styrene blocks is reduced by the dispersion of the filler 428.

According to an embodiment, the thermal conductor 420 may be a composite comprising the first compound 426, the 1-1th compound 426a, the second compound 427, the filler 428, and the additive 429. The thermal conductor 420 according to an embodiment of the disclosure may enhance compressibility of the thermal conductor 420 by adjusting the weight ratio of each compound in the composite. The thermal conductor 420 according to an embodiment of the disclosure may enhance the compressibility of the thermal conductor 420 by adjusting the weight ratio between the molecules constituting the first compound 426.

According to an embodiment, the first compound 426 may include a first molecule 4261 and a second molecule 4262. The first molecule 4261 may include a hydrocarbon. The first molecule 4261 may include ethylene and butylene. The second molecule 4262 may include styrene. The first compound 426 may be a molecule in which a hydrocarbon (e.g., ethylene, butylene) and styrene are chemically bonded.

According to an embodiment, the 1-1th compound 426a may include a first molecule 4261 and a second molecule 4262. The first molecule 4261 may include a hydrocarbon. The 1-1th compound 426a may be a molecule in which a hydrocarbon (e.g., ethylene, butylene) and styrene are chemically bonded.

According to an embodiment, the weight ratio of styrene constituting the first compound 426 and the weight ratio of styrene constituting the 1-1th compound 426a may be different. The weight ratio (e.g., the first weight ratio) of styrene contained in the first compound 426 to the weight of the first compound 426 may be smaller than the weight ratio (e.g., the 1-1th weight ratio) of styrene contained in the 1-1th compound 426a to the weight of the 1-1th compound 426a.

According to an embodiment, the thermal conductor 420 may include the first compound 426 having the first weight ratio and the 1-1th compound 426a having the 1-1th weight ratio. The thermal conductor 420 may include a first compound 426 having a relatively low weight ratio of styrene and a 1-1th compound 426a having a relatively high weight ratio of styrene. For example, the first weight ratio may be about 10 wt%. For example, the 1-1th weight ratio may be about 30 wt%. When the thermal conductor 420 includes only the first compound 426 without including the 1-1th compound 426a, the fluidity of the thermal conductor 420 may be excessively increased, and thus it may be difficult to reuse the thermal conductor 420 because the formality of the thermal conductor 420 may not be secured. Further, when the thermal conductor 420 does not contain the first compound 426 but only the 1-1th compound 426a, the compressibility of the thermal conductor 420 may not be achieved. Therefore, the thermal conductor 420 may include the first compound 426 of the first weight ratio and the 1-1th compound 426a of the 1-1th weight ratio, thereby securing reuse and compressibility. This is described in detail later.

According to an embodiment, the molecular weight of the first compound 426 and/or the 1-1th compound 426a may range from 100,000 to 150,000 MW (molecular weight). The ratio of the weight of the second molecule 4262 to the weight of the first compound 426 or the 1-1th compound 426a may be defined as a styrene weight ratio. The weight ratio of styrene may be in the range of 10 to 30 wt%. The ratio of the weight of the first compound 426 to the weight of the second compound 427 may be defined as a second weight ratio. The second weight ratio may be in the range of 40 to 60 wt%. The ratio of the weight of the filler 428 to the whole weight of the thermal conductor 420 may be defined as the third weight ratio. The third weight ratio may be in the range of 70 to 90 wt%. The thermal conductivity of the thermal conductor 420 may range from 3 W to 10 W.

Referring to FIGS. 9 and 10, the thermal conductor 420 may be assembled with the substrate assembly 400 by being deformed from the state of FIG. 9 to the state of FIG. 10. The method for manufacturing a substrate assembly 400 may include disposing (e.g., a first operation) a shielding sheet 410 to which a thermal conductor 420 is coupled on an electrical component 401. The method for manufacturing the substrate assembly 400 may include pressing (e.g., a second operation) the shielding sheet 410 to which the thermal conductor 420 is coupled toward a printed circuit board 403. The method for manufacturing the substrate assembly 400 may include deforming (e.g., a third operation) the thermal conductor 420 to surround the electrical component 401 by compression. The method for manufacturing the substrate assembly 400 may include filling (e.g., a fourth operation) a space formed between electrical components 401 with the thermal conductor 420.

Referring to FIGS. 9 and 10, the thermal conductor 420 may be separated from the substrate assembly 400 by being deformed from the state of FIG. 10 to the state of FIG. 9. The thermal conductor 420 may be separated from the substrate assembly 400 together with the shielding sheet 410 by separating the shielding sheet 410 to which the thermal conductor 420 is coupled from the shield can 404.

The thermal conductor 420 according to an embodiment of the disclosure may have enhanced compressibility due to the chemical characteristics described with reference to FIGS. 12 to 14. Due to the above-described chemical characteristics, the thermal conductor 420 may be easily assembled to the substrate assembly 400, as described with reference to FIGS. 9 and 10. Due to the chemical characteristics, the thermal conductor 420 may be easily separated from the substrate assembly 400 as described with reference to FIGS. 9 and 10. The thermal conductor 420 may be reused at the substrate assembly 400 after being separated from the substrate assembly 400 due to the above-described chemical characteristics (particularly, the characteristic of compressibility being enhanced) as described with reference to FIG. 11. Due to the above-described chemical characteristics, the thermal conductor 420 may not leave debris in the substrate assembly 400 when separated from the substrate assembly 400.

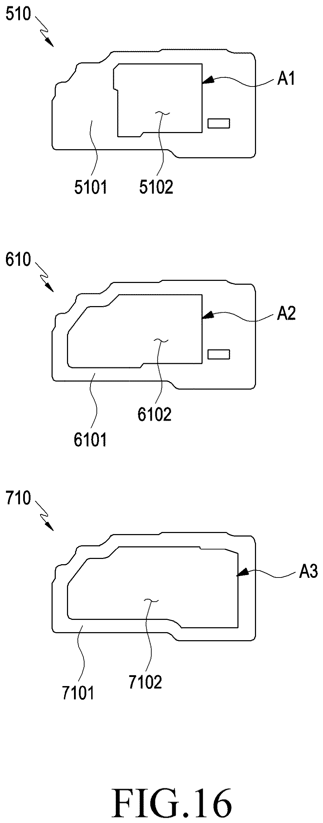

FIG. 15 is a view illustrating a thermal conductor 420 or 520 and a shielding sheet 410 according to an embodiment of the disclosure. Some or all of the components described with reference to FIG. 15 may be the same as all or some of the components described with reference to FIGS. 1 to 14. Some or all of the components described with reference to FIG. 15 may be the same as all or some of the components described with reference to FIG. 16 or 16.

According to an embodiment, the thermal conductor 420 may include a first thermal conduction portion 4201 and a second thermal conduction portion 4202. The first thickness t1 of the first thermal conduction portion 4201 may be substantially the same as the second thickness t2 of the second thermal conduction portion 4202.

According to an embodiment, the thermal conductor 520 may include a first thermal conduction portion 5201 and a second thermal conduction portion 5202. The first thickness t3 of the first heat conduction portion 5201 may be smaller than the second thickness t4 of the second heat conduction portion 5202. The first thermal conduction portion 5201 may include the first portion 421 described with reference to FIG. 10. The second thermal conduction portion 5202 may include the second portion 424 described with reference to FIG. 10.

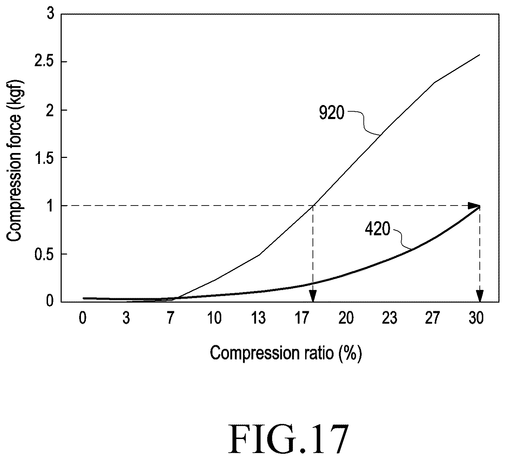

FIG. 16 is a view illustrating a shielding sheet 510, 610, or 710 according to an embodiment of the disclosure. Some or all of the components described with reference to FIG. 16 may be the same as those described with reference to FIGS. 1 to 15. Some or all of the components described with reference to FIG. 16 may be the same as all or some of the components described with reference to FIG. 17.

According to an embodiment, the shielding sheet 510, 610, or 710 may include a body 5101, 6101, or 7101 and an opening 5102, 6102, or 7102. The shielding sheets 510, 610, and 710 illustrated in FIG. 16 may include openings 5102, 6102, and 7102 having different areas A1, A2, and A3.

FIG. 17 is a graph comparing compressibility of a thermal conductor 420 according to an embodiment of the disclosure with compressibility of a thermal conductor 920 according to a comparative embodiment. Some or all of the components described with reference to FIG. 17 may be the same as all or some of the components described with reference to FIGS. 1 to 16.

Referring to FIG. 17, it may be identified that when the same compression force is applied, the compression ratio of the thermal conductor 420 according to the embodiment of the disclosure is larger than that of the thermal conductor 920 according to the comparative embodiment.

As electronic devices become more compact and perform more functions, a problem that arises is that of heat generation. The components of the electronic device may generate heat as they perform their functions, and if this heat is not dissipated then the electronic device will eventually experience overheating, which may lead to a malfunction.

To that end, arrangements must be made in the design of an electronic device to provide for the dissipation of heat into an environment around the electronic device. However, it may be difficult to arrange for the flow of heat from a component on the interior of the electronic device to an exterior of the electronic device.

The electronic device may include a substrate assembly on which an electrical component generating heat is disposed. The electronic device includes a heat dissipation member for dissipating heat generated from the substrate assembly. The heat dissipation member may be assembled to the substrate assembly. When the heat dissipation member is separated from the substrate assembly, debris of the heat dissipation member may remain in the substrate assembly. When the heat dissipation member is separated from the substrate assembly, the heat dissipation member may be damaged so that the heat dissipation member may not be reused.

An objective to be addressed by the disclosure may involve reusing the thermal conductor.

An objective to be addressed by the disclosure may be to enhance the compressibility of the thermal conductor.

The objectives to be addressed by the disclosure are not limited to those mentioned, but may rather be diverse without departing from the spirit and scope of the disclosure.

The electronic device according to various embodiments of the disclosure may reassemble the thermal conductor with the substrate assembly after the thermal conductor is separated from the substrate assembly by enhancing the compressibility of the thermal conductor.

The electronic device according to various embodiments of the disclosure may enhance the compressibility of the thermal conductor by adjusting the composition of the compounds included in the thermal conductor.

Effects obtainable from the disclosure are not limited to the above-mentioned effects, and other effects not mentioned may be apparent to one of ordinary skill in the art from the aforementioned description.

An electronic device (e.g., 101 of FIGS. 1 to 17) according to an embodiment of the disclosure may comprise a housing (e.g., 301 of FIGS. 1 to 17).

The electronic device (e.g., 101 of FIGS. 1 to 17) according to an embodiment of the disclosure may comprise a printed circuit board (e.g., 403 of FIGS. 1 to 17) disposed in the housing (e.g., 301 of FIGS. 1 to 17).

The electronic device (e.g., 101 of FIGS. 1 to 17) according to an embodiment of the disclosure may comprise an electrical component (e.g., 401 of FIGS. 1 to 17) disposed on the printed circuit board (e.g., 403 of FIGS. 1 to 17).

The electronic device (e.g., 101 of FIGS. 1 to 17) according to an embodiment of the disclosure may comprise a thermal conductor (e.g., 420 of FIGS. 1 to 17) configured to exchange heat with the electrical component (e.g., 401 of FIGS. 1 to 17).

The thermal conductor (e.g., 420 of FIGS. 1 to 17) according to an embodiment of the disclosure may include a first portion (e.g., 421 of FIGS. 1 to 17) spaced apart from the printed circuit board (e.g., 403 of FIGS. 1 to 17).

The thermal conductor (e.g., 420 of FIGS. 1 to 17) according to an embodiment of the disclosure may include a second portion (e.g., 424 of FIGS. 1 to 17) extending from the first portion (e.g., 421 of FIGS. 1 to 17) toward the printed circuit board (e.g., 403 of FIGS. 1 to 17) and disposed around the electrical component (e.g., 401 of FIGS. 1 to 17).

The electronic device (e.g., 101 of FIGS. 1 to 17) according to an embodiment of the disclosure may comprise a shield can (e.g., 404 of FIGS. 1 to 17) including a receiving space (e.g., 402 of FIGS. 1 to 17) in which the electrical component (e.g., 401 of FIGS. 1 or 16) is located.

The thermal conductor (e.g., 420 of FIGS. 1 to 17) according to an embodiment of the disclosure may be configured to be deformable in the receiving space (e.g., 402 of FIGS. 1 to 17).

The electrical component (e.g., 401 of FIGS. 1 to 17) according to an embodiment of the disclosure may include at least one processor (e.g., 4011 of FIGS. 1 to 17)).

The electrical component (e.g., 401 of FIGS. 1 to 17) according to an embodiment of the disclosure may include memory (e.g., 4012 of FIGS. 1 to 17)) stacked with the at least one processor (e.g., 4011 of FIGS. 1 to 17).

The thermal conductor (e.g., 420 of FIGS. 1 to 17) according to an embodiment of the disclosure may include a first conduction portion (e.g., 422 of FIGS. 1 to 17) disposed around the at least one processor (e.g., 4011 of FIGS. 1 to 17).

The thermal conductor (e.g., 420 of FIGS. 1 to 17) according to an embodiment of the disclosure may include a second conduction portion (e.g., 423 of FIGS. 1 to 17) disposed around the memory (e.g., 4012 of FIGS. 1 to 17).

The electronic device (e.g., 101 of FIGS. 1 to 17) according to an embodiment of the disclosure may include a shielding sheet (e.g., 410 of FIGS. 1 to 17) covering the electrical component (e.g., 401 of FIGS. 1 to 17), and coupled to the thermal conductor (e.g., 420 of FIGS. 1 to 17).

The thermal conductor (e.g., 420 of FIGS. 1 to 17) according to an embodiment of the disclosure may be configured to be deformable by compression by the shielding sheet (e.g., 410 of FIGS. 1 to 17).

The electronic device (e.g., 101 of FIGS. 1 to 17) according to an embodiment of the disclosure may comprise a substrate assembly (e.g., 400 of FIGS. 1 to 17) including the printed circuit board (e.g., 403 of FIGS. 1 to 17) and the electrical component (e.g., 401 of FIGS. 1 to 17).

The thermal conductor (e.g., 420 of FIGS. 1 to 17) according to an embodiment of the disclosure may be configured to be repeatedly couplable to the substrate assembly or to be repeatedly detachable from the substrate assembly (e.g., 400 of FIGS. 1 to 17).

According to an embodiment of the disclosure, A first thickness of the first portion (e.g., 421 of FIGS. 1 to 17) may be smaller than a second thickness of the second portion (e.g., 424 of FIGS. 1 to 17).

According to an embodiment of the disclosure, the thermal conductor (e.g., 420 of FIGS. 1 to 17) may include a first compound (e.g., 426 of FIGS. 1 to 17) including a first molecule (e.g., 4261 of FIGS. 1 to 17) and a second molecule (e.g., 4262 of FIGS. 1 to 17), wherein the second molecule includes styrene.

According to an embodiment of the disclosure, the thermal conductor (e.g., 420 of FIGS. 1 to 17) may include a first compound (e.g., 426 of FIGS. 1 to 17) including a first molecule (e.g., 4261 of FIGS. 1 to 17) including hydrocarbon and a second molecule (e.g., 4262 of FIGS. 1 to 17) including styrene.

According to an embodiment of the disclosure, the thermal conductor (e.g., 420 of FIGS. 1 to 17) may include a 1-1th compound (e.g., 426a of FIGS. 1 to 17) including the first molecule (e.g., 4261 of FIGS. 1 to 17) and the second molecule (e.g., 4262 of FIGS. 1 to 17).

A first weight ratio of the second molecule (e.g., 4262 of FIGS. 1 to 17) included in the first compound (e.g., 426 of FIGS. 1 to 17) according to an embodiment of the disclosure may be smaller than a 1-1th weight ratio of the second molecule (e.g., 4262 of FIGS. 1 to 17) included in the 1-1th compound (e.g., 426a of FIGS. 1 to 17).

The thermal conductor (e.g., 420 of FIGS. 1 to 17) according to an embodiment of the disclosure may include an additive (e.g., 429 of FIGS. 1 to 17) surrounding surfaces of the first compound (e.g., 426 of FIGS. 1 to 17) and the 1-1th compound (e.g., 426a of FIGS. 1 to 17).

The thermal conductor (e.g., 420 of FIGS. 1 to 17) according to an embodiment of the disclosure may include a second compound (e.g., 427 of FIGS. 1 to 17) including a phase change material (PCM).

A second weight ratio of the first compound (e.g., 426 of FIGS. 1 to 17) to the second compound (e.g., 427 of FIGS. 1 to 17) according to an embodiment of the disclosure may be 40wt% to 60wt%.

According to an embodiment of the disclosure, the thermal conductor (e.g., 420 of FIGS. 1 to 17) may include a filler (e.g., 428 of FIGS. 1 to 17) disposed between the first compound (e.g., 426 of FIGS. 1 to 17) and the 1-1th compound (e.g., 426a of FIGS. 1 to 17).

A third weight ratio of the filler (e.g., 426 of FIGS. 1 to 17) to a whole weight of the thermal conductor (e.g., 420 of FIGS. 1 to 17) according to an embodiment of the disclosure may be 70wt% to 90wt%.

The first weight ratio according to an embodiment of the disclosure may be 10wt% to 30wt%.

A method for manufacturing a substrate assembly (e.g., 400 of FIGS. 1 to 17) according to an embodiment of the disclosure may comprise disposing a shielding sheet (e.g., 410 of FIGS. 1 to 17), to which a thermal conductor (e.g., 420 of FIGS. 1 to 17) is coupled, on a printed circuit board (e.g., 403 of FIGS. 1 to 17) on which an electrical component (e.g., 401 of FIGS. 1 to 17) is disposed.

The method for manufacturing the substrate assembly (e.g., 400 of FIGS. 1 to 17) according to an embodiment of the disclosure may comprise pressing the shielding sheet (e.g., 410 of FIGS. 1 to 17), to which the thermal conductor (e.g., 420 of FIGS. 1 to 17) is coupled, toward the printed circuit board (e.g., 403 of FIGS. 1 to 17).

The method for manufacturing the substrate assembly (e.g., 400 of FIGS. 1 to 17) according to an embodiment of the disclosure may comprise deforming the thermal conductor (e.g., 420 of FIGS. 1 to 17) to surround the electrical component (e.g., 401 of FIGS. 1 to 17) by compression.

According to an embodiment of the present disclosure, an electrical component may have a first side which is adjacent to the printed circuit board. The thermal conductor may surround the at least one electrical component by being in contact with at least a majority of a second side of the electrical component which is opposite to the first side of the electrical component, and by being in contact with at least a majority of a third side of the electrical component which is not the first side or the second side. The thermal conductor may surround the at least one electrical component by being in contact with substantially all of the second side of the electrical component, and by being in contact with substantially all of the third side of the electrical component. The thermal conductor may surround the at least one electrical component by being in contact with substantially all of the outer surfaces of the electrical component except for the first side of the electrical component.

According to an embodiment of the disclosure, an thermal conductor according to an embodiment of the disclosure may comprise a first styrene compound including a first molecule and a second molecule, wherein the second molecule includes styrene. The thermal conductor may further include a second styrene compound including the first molecule and the second molecule, wherein a first weight ratio of the second molecule included in the first styrene compound is smaller than a second weight ratio of the second molecule included in the second styrene compound.

According to an embodiment of the disclosure, the first molecule may include hydrocarbon.

According to an embodiment of the disclosure, the first weight ratio is in a range of 10wt% to 30wt%.

According to an embodiment of the disclosure, the thermal conductor may further comprise a phase change material compound including a phase change material (PCM). A second weight ratio of the first styrene compound to the second compound may be 40wt% to 60wt%.

According to an embodiment of the present disclosure, the thermal conductor may further comprise a filler disposed between the first styrene compound and the second styrene compound. A third weight ratio of the filler to a whole weight of the thermal conductor may be 70wt% to 90wt%.

While the disclosure has been shown and described with reference to exemplary embodiments thereof, it will be apparent to those of ordinary skill in the art that various changes in form and detail may be made thereto without departing from the scope of the disclosure as defined by the following claims.

While the disclosure has been described and shown in connection with an embodiment thereof, it should be appreciated that an embodiment is intended as limiting the disclosure but as illustrative. It will be apparent to one of ordinary skill in the art that various changes may be made in form and detail without departing from the overall scope of the disclosure, including the appended claims.

It will be appreciated that all of the above-described embodiments, and their technical features, may be combined with one another in each and every combination, potentially unless there is a conflict between two embodiments or features. That is, each and every combination of two or more of the above-described embodiments is envisaged and included within the present disclosure. One or more features from any embodiment may be incorporated in any other embodiment, and provide a corresponding advantage or advantages.

## Claims

1. An electronic device (101) comprising:
a housing (301);
a printed circuit board (403) disposed in the housing (301);
an electrical component (401) disposed on the printed circuit board (403); and
a thermal conductor (420) configured to exchange heat with the electrical component,
wherein the thermal conductor (420) includes:
a first portion (421) spaced apart from the printed circuit board (403); and
a second portion (424) extending from the first portion (421) toward the printed circuit board (403), and disposed around the electrical component (401).

2. The electronic device of claim 1, further comprising
a shield can (404) including a receiving space (402) in which the electrical component (401) is located,
wherein the thermal conductor (420) is configured to be deformable in the receiving space (402).

3. The electronic device of claim 1 or 2,
wherein the electrical component (401) includes:
at least one processor (4011); and
memory (4012) stacked with the at least one processor (4011),
and wherein the thermal conductor (420) includes:
a first conduction portion (422) disposed around the at least one processor (4011); and
a second conduction portion (424) disposed around the memory (4012).

4. The electronic device of any one of claims 1 to 3, further comprising
a shielding sheet (410) covering the electrical component (401), and coupled to the thermal conductor (420),
wherein the thermal conductor (420) is configured to be deformable by compression by the shielding sheet (410).

5. The electronic device of any one of claims 1 to 4, further comprising
a substrate assembly (400) comprising the printed circuit board (403) and the electrical component (401),
wherein the thermal conductor (420) is configured to be repeatedly couplable to the substrate assembly (400) or to be repeatedly detachable from the substrate assembly (400).

6. The electronic device of any one of claims 1 to 5,
wherein a first thickness of the first portion (421) is smaller than a second thickness of the second portion (424).

7. The electronic device of any one of claims 1 to 6,
wherein the thermal conductor (420) includes:
a first compound (426) including a first molecule (4261) including hydrocarbon and a second molecule (4262) including styrene; and
a 1-1th compound (426a) including the first molecule (4261) and the second molecule (4262),
and wherein a first weight ratio of the second molecule (4262) included in the first compound (426) is smaller than a 1-1th weight ratio of the second molecule (4262) included in the 1-1th compound (426a).

8. The electronic device of claim 7,
wherein the thermal conductor (420) includes:
an additive (429) surrounding surfaces of the first compound (426) and the 1-1th compound (426a).

9. The electronic device of claim 7 or 8,
wherein the thermal conductor (420) includes:
a second compound (427) including a phase change material (PCM),
and wherein a second weight ratio of the first compound (426) to the second compound (427) is 40wt% to 60wt%.

10. The electronic device of any one of claims 7 to 9,
wherein the thermal conductor (420) includes:
a filler (428) disposed between the first compound (426) and the 1-1th compound (426a),
and wherein a third weight ratio of the filler (426) to a whole weight of the thermal conductor (420) is 70wt% to 90wt%.

11. The electronic device of claim 1,
wherein the electrical component (401) comprises a plurality of electrical components (4011, 4012, 4013, 4014, 4015),
wherein the second portion (424) of the thermal conductor (420) is positioned between two adjacent electrical components (4011, 4013) among the plurality of electrical components (4011, 4012, 4013, 4014, 4015).

12. The electronic device of claim 7,
wherein the thermal conductor (420) comprises a filler (428) and a surfactant (429), the surfactant (429) is coated on a surface of the filler (428).

13. The electronic device of claim 1,
wherein the thermal conductor (420) comprises a phase change material, and
wherein the thermal conductor (420) is configured to be in a solid phase in room temperature and to be softened from the solid phase by heat generated in the electrical component (401).

14. The electronic device of claim 1,
wherein the first portion (421) of the thermal conductor (420) is in contact with a top surface of the electrical component (401), and
wherein the second portion (424) of the thermal conductor (420) is in contact with a side surface of the electrical component (401).

15. The electronic device of claim 1,
wherein, in room temperature, the thermal conductor (420) is configured to maintain shape after separated from the electrical component (401).
